# EUROPÄISCHE PATENTSCHRIFT

(11) **EP 1 005 064 B1**
(45) Veröffentlichungstag und Bekanntmachung des Hinweises auf die Patenterteilung: **19.09.2001**
(21) Anmeldenummer: 99123323.0
(22) Anmeldetag: 23.11.1999
(51) Int. Cl.: H01L 21/00

(54) **Vorrichtung zum Nassätzen einer Kante einer Halbleiterscheibe**
Apparatus for wet etching the edge of a semiconductor wafer
Appareil pour gravure humide d'un bord d'une plaquette semiconductrice

(30) Priorität: 27.11.1998 DE 19854743
(43) Veröffentlichungstag der Anmeldung: 31.05.2000
(73) Patentinhaber: SEZ Semiconductor-Equipment Zubehör für die Halbleiterfertigung AG, 9500 Villach (AT)
(72) Erfinder: Sellmer, Reinhard, Dipl.-Ing. (FH), 9500 Villach (AT); Kumnig, Robert, 9815 Kolbnitz (AT)

(56) Entgegenhaltungen:
- US-A- 5 641 391

## Beschreibung

Die Erfindung betrifft eine Vorrichtung zum Naßätzen einer Kante einer Halbleiterscheibe.

Derartige Vorrichtungen sind beispielsweise aus der EP 0 297 648 B1 und EP 0 368 334 B1 bekannt.

Beispielsweise zur Herstellung von Chips auf sogenannten Smart-Cards (zum Beispiel Kreditkarten) oder SIM-Cards (zum Beispiel für Mobiltelefone) müssen die entsprechenden Vorprodukte, die sogenannten Wafer (Halbleiterscheiben), die beispielsweise eine Dicke von 0,5 bis 2 mm aufweisen, auf eine Materialstärke von beispielsweise 50 bis 200 µm reduziert werden.

Dies geschieht beispielsweise durch Schleifen und anschließendes Polieren, aber auch durch sogenanntes Dünnätzen mit naßchemischen Methoden.

Die Kante des Wafers, die ursprünglich abgerundet ist, weist anschließend eine keil- oder pfeilförmige Form auf.

Hieraus entsteht das Problem, daß durch die entsprechend messerscharfe Kante beispielsweise beim Transport des Wafers andere Bauteile ebenso beschädigt werden können, wie die Kante des Wafers selbst. Dies gilt insbesondere dann, wenn der Wafer auf die gewünschte Stärke abgeschliffen wird, da sich durch die starke mechanische Beanspruchung im Randbereich Mikrorisse (Haarrisse) ausbilden.

Zum "Entgraten" beziehungsweise "Entschärfen" der Kante eines Halbleiters schlägt die EP 0 297 648 B1 vor, die rotierende Halbleiterscheibe im Randbereich durch ein mit Säure getränktes Kissen zu führen, wodurch der Rand geätzt und damit teilweise abgetragen wird.

Gemäß der EP 0 368 334 B1 wird das gleiche Ziel durch eine Vorrichtung erreicht, bei der der rotierende Wafer umfangsseitig gegen eine mit einem Ätzmittel belegte Nut einer rotierenden Rolle geführt wird.

Nachteilig in beiden Verfahren und Vorrichtungen ist, daß zusätzliche Vorrichtungsteile (Kissen, Rolle mit Nut) benötigt werden und ein mechanischer Kontakt zwischen der Waferkante und diesen zusätzlichen Vorrichtungsteilen zum Abtragen der Kante notwendig ist. Dabei können sich zum Beispiel Partikel aus dem Kissen lösen und den Wafer verunreinigen. Außerdem können durch den mechanischen Kontakt Unregelmäßigkeiten in der sehr dünnen Waferkante entstehen.

Aufgabe der Erfindung ist es deshalb, eine Vorrichtung der eingangs genannten Art zur Verfügung zu stellen, die ein definiertes Entgraten von Waferkanten ohne die Gefahr von Verunreinigungen des Wafers erlaubt.

Grundgedanke der Erfindung dabei ist es, eine Ätzflüssigkeit gezielt auf den zu behandelnden Randabschnitt (Kantenbereich) des Wafers zu führen, so daß es ausschließlich zu einem Kontakt der Ätzflüssigkeit mit der Waferkante kommt und keine mechanische Verbindung der Waferkante zu benachbarten Bauteilen besteht.

In diesem Zusammenhang hätte es zunächst nahegelegen, die Ätzflüssigkeit senkrecht von oben auf einen horizontal auf einem Träger aufliegenden und rotierenden Wafer zu führen. Diese Technologie hat sich jedoch als unbrauchbar erwiesen, weil in jedem Fall auch die Unterseite des Wafers unerwünscht angeätzt wurde. Der Grund hierfür scheint darin zu liegen, daß die Säure in die Wafermatrix diffundiert, sich dann durch eine exotherme Reaktion des Ätzvorgangs erwärmt und auf der Unterseite des Wafers Silizium aus der Halbleiterscheibe löst.

In umfangreichen Versuchen wurde schließlich festgestellt, daß die erfindungsgemäße Aufgabe dann gelöst wird, wenn die Ätzflüssigkeit in einem Strahl auf den zu behandelnden Kantenbereich des Wafers geführt wird, der unter einem Winkel < 90 Grad und > 0 Grad zur Ebene der Halbleiterscheibe verläuft, insbesondere unter einem Winkel zwischen 1 und 25 Grad.

Durch diese "Schrägstellung" des Strahls der Ätzflüssigkeit trifft die Ätzflüssigkeit "weich" auf die Waferkante auf und wird nach extrem kurzer Behandlungsdauer in Zuführrichtung der Ätzflüssigkeit wieder abgeschleudert.

Zudem ermöglicht diese Technologie die Zuführung des Ätzflüssigkeitsstrahls auf einen definierten Flächenabschnitt der Kante der zu behandelnden Halbleiterscheibe, wobei dieser Flächenabschnitt abhängig von der Größe des Ätzstrahls ist und infinitesimal klein sein kann.

In ihrer allgemeinsten Ausführungsform betrifft die Erfindung danach eine Vorrichtung zum Naßätzen einer Kante einer Halbleiterscheibe, mit folgenden Merkmalen:
- einem Träger mit einer Trägerfläche zur rotierenden Aufnahme der Halbleiterscheibe, sowie
- einer oberhalb der Halbleiterscheibe angeordneten Düse, deren Mündungsabschnitt so ausgebildet und ausgerichtet ist, daß ein über den Mündungsabschnitt austretender Ätzflüssigkeitsstrahl unter einem Winkel > 0 und < 90 Grad zur Ebene der Halbleiterscheibe auf einen definierten Flächenabschnitt der Kante der zu behandelnden Halbleiterscheibe auftrifft.

Bezogen auf die Halbleiterscheibe kann die Düse beziehungsweise deren Mündungsabschnitt prinzipiell radial ausgerichtet sein. In diesem Fall verläßt die Ätzflüssigkeit die Düse zum Beispiel mittig über der Halbleiterscheibe. Der Mündungsabschnitt ist dabei so ausgerichtet und der Flüssigkeitsdruck so eingestellt, daß der Flüssigkeitsstrahl "von innen nach außen" genau in dem zu behandelnden Kantenbereich des Wafers auf die Waferkante trifft, und zwar unter einem der vorstehend genannten Winkel.

Nach einer anderen Ausführungsform, die sich als besonders effektiv erwiesen hat, ist der Mündungsabschnitt der Düse so ausgerichtet, daß der Ätzflüssigkeitsstrahl tangential zur Kante der Halbleiterscheibe verläuft. Mit anderen Worten: Die Düse beziehungsweise deren Mündungsabschnitt liegt hierbei außerhalb der Halbleiterscheibe und der Mündungsabschnitt ist im wesentlichen tangential zur Kante der Halbleiterscheibe ausgerichtet. Auch hier gilt aber wiederum, daß der Mündungsabschnitt so ausgerichtet ist, daß der Ätzflüssigkeitsstrahl unter einem der vorgenannten Winkel geneigt zur Ebene der Halbleiterscheibe verläuft und auf die zu behandelnde Kante der Halbleiterscheibe auftrifft.

Das letztgenannte Ausführungsbeispiel ist in der folgenden Figurenbeschreibung im einzelnen dargestellt.

Die Ausrichtung der Düse beziehungsweise des Mündungsabschnittes der Düse kann dabei so erfolgen, daß der Ätzflüssigkeitsstrahl ausschließlich auf einen der Düse zugewandten Flächenabschnitt der Kante der Halbleiterscheibe auftrifft. Die Düse beziehungsweise deren Mündungsabschnitt ist hierbei also exakt in der Weise positioniert, daß der Flüssigkeitsstrahl vollständig auf den Kantenbereich des Wafers auftrifft und auch nicht teilweise an der Waferkante frei vorbeigeführt wird. Auf diese Weise wird zum einen eine höchstmögliche Ausbeute der Ätzflüssigkeit erreicht und zum anderen jede Gefahr einer sogenannten "Unterätzung" (Ätzung der der Düse abgewandten Seite des Wafers) vermieden. Schließlich kann auf diese Weise die gesamte, nicht verbrauchte Ätzflüssigkeit wieder aufgefangen und in das System zurückgeführt werden.

Dies gilt insbesondere im Zusammenhang mit der vorstehend beschriebenen tangentialen Zuführung des Ätzflüssigkeitsstrahls, der entsprechend tangential anschließend von der Waferkante abgeschleudert wird und aufgefangen werden kann.

Die tangentiale oder annähernd tangentiale Zuführung der Ätzflüssigkeit verhindert jedes unkontrollierte Wegspritzen der Ätzflüssigkeit beim Auftreffen auf die Waferkante, weil die Ätzflüssigkeit in Drehrichtung des Wafers zugeführt werden kann.

in diesem Zusammenhang schlägt eine weitere Ausführungsform der Erfindung vor, die Düse so auszubilden und anzuordnen, daß der Ätzflüssigkeitsstrahl beim Auftreffen auf die Kante der Halbleiterscheibe eine Strömungsgeschwindigkeit aufweist, die maximal der Umfangsgeschwindigkeit der Halbleiterscheibe entspricht.

Es hat sich nämlich überraschend herausgestellt, daß nicht nur die Form des Ätzstrahls einen Einfluß auf das Entgraten der Waferkante hat, sondern auch der Druck (die Strömungsgeschwindigkeit) der Ätzflüssigkeit wesentlich für ein optimiertes Entgraten der Waferkante ist. Entgegen der Annahme, daß eine besonders hohe Strömungsgeschwindigkeit vorteilhaft ist hat sich herausgestellt, daß die Strömungsgeschwindigkeit geringer als die Umfangsgeschwindigkeit der Halbleiterscheibe sein sollte, vorzugsweise bis zu einer Zehnerpotenz geringer. Aus diesem Grund ist auch eine laminare Strömung der Ätzflüssigkeit von Vorteil.

Ausgehend von konventionellen Wafern mit einem Durchmesser von beispielsweise 150 bis 300 mm kann der Mündungsabschnitt der Düse einen Durchmesser zwischen 0,2 und 1,0 mm aufweisen. Während die Umfangsgeschwindigkeit des Wafers üblicherweise bei etwa 20 m/s liegt sollte die Strömungsgeschwindigkeit der Ätzflüssigkeit zwischen 90 und 50 % darunter liegen.

Die Ausrichtung der Düse beziehungsweise ihres Mündungsabschnittes erfolgt nach einer Ausführungsform derart, daß der Ätzflüssigkeitsstrahl unter einem Winkel zwischen 1 und 25 Grad, bezogen auf die Ebene des Wafers, auf die Waferkante auftrifft.

Weiters schlägt die Erfindung vor, die Vorrichtung mit einem Träger auszubilden, der mindestens eine in die Trägerfläche mündende Düse zur Aufnahme der Halbleiterscheibe nach dem Bernoulli-Prinzip aufweist. Ein entsprechender Träger ergibt sich beispielsweise aus der EP 0 611 273 A1 oder der WO 97/03457. Auf diese Weise wird sichergestellt, daß die dem Träger zugewandte Unterseite des Wafers und auch der Träger selbst nicht von der Ätzflüssigkeit benetzt werden können, und zwar auch dann nicht, wenn der Ätzstrahl nicht vollständig auf die Oberseite der Waferkante auftrifft, wie vorstehend beschrieben.

Bei einer weiteren Ausführungsform besitzt die Vorrichtung einen Träger, der mindestens eine, in die Trägerfläche mündende Düse aufweist, die zur Fixierung der Halbleiterscheibe mit Unterdruck (Vakuum) beaufschlagbar ist.

Schließlich schlägt die Erfindung vor, die Vorrichtung mit einem Träger auszubilden der einen Durchmesser aufweist, der kleiner ist als der Durchmesser der zu behandelnden Halbleiterscheibe. Dadurch wird bewirkt, daß Flüssigkeit, die an der Halbleiterscheibe vorbeiströmt oder von dieser abrinnt nicht auf den Träger trifft, und so auch nicht die dem Träger zugewandte Oberfläche der Halbleiterscheibe benetzen kann.

Weitere Merkmale der Erfindung ergeben sich aus den Merkmalen der Unteransprüche sowie den sonstigen Anmeldungsunterlagen.

In der nachfolgenden Figurenbeschreibung, die ein Ausführungsbeispiel zeigt, offenbaren, jeweils in stark schematisierter Darstellung:
- Figur 1:: eine Aufsicht auf eine erfindungsgemäße Vorrichtung,
- Figur 2:: eine Seitenansicht einer erfindungsgemäßen Vorrichtung,
- Figur 3:: eine vergrößerte Schnittdarstellung der Vorrichtung im Ätzbereich einer Waferkante.

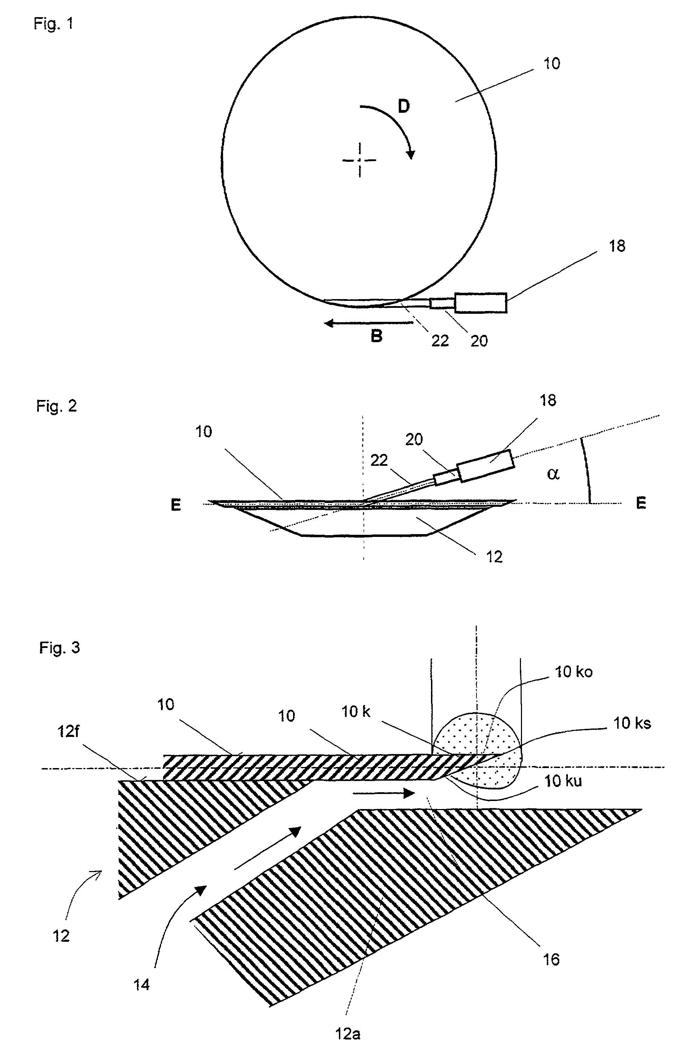

Aus einer Zusammenschau der Figuren 1 bis 3 ergibt sich, daß eine sehr dünne Waferscheibe 10 (hier: 50 µm dick) auf einem rotierenden Träger drehbar geführt wird. Dabei ist die Dicke des Wafers 10 lediglich zur besseren Darstellung übertrieben dick gezeichnet.

Aus Figur 3 ergibt sich eine typische Geometrie des Wafers 10 im umfangseitigen Kantenbereich 10k. Während die Oberseite 10ko im Kantenbereich 10k fluchtend zur Oberseite 10o des Wafers 10 insgesamt verläuft ist die Unterseite 10ku abgeschrägt ausgebildet, womit sich insgesamt ein messerartiges, scharfkantiges Profil mit einer Spitze 10ks ergibt. Gemäß Figur 3 weist der Träger 12 eine Ringdüse 14 auf, die in seine Trägerfläche 12f einmündet, auf der der Wafer 10 geführt wird. Ein durch die Ringdüse 14 geführter Gasstrom, beispielsweise Stickstoff, strömt über die Ringdüse 14 aus und gelangt in einen ringförmigen Abschnitt 16, der zwischen dem Wafer 10 und einem abgesenkten Abschnitt 12a des Trägers 12 ausgebildet wird. Durch das schnellströmende Gas bildet sich in diesem ringförmigen Abschnitt 16 ein Unterdruck, wodurch der Wafer 10 gegen die Trägerfläche 12f des Trägers 12 gesaugt wird (sogenannter Bernoulli-Effekt). Der in Figur 3 dargestellte Träger wird auch als Bernoulli-Chuck bezeichnet.

Oberhalb und außerhalb des Wafers 10 ist eine Düse 18 angeordnet, die einen Mündungsabschnitt 20 aufweist, aus dem unter Druck eine Ätzflüssigkeit austritt und - wie Figur 3 zeigt - auf die Oberseite 10ko der Waferkante 10k geführt wird.

Aus einer Zusammenschau der Figuren 1 und 2 folgt, daß die Strömungsrichtung B der Ätzflüssigkeit der Drehrichtung D des Wafers entspricht. Hierdurch wird ein "welches" Auftreffen der Ätzflüssigkeit auf die Waferkante 10k erreicht.

Aus einer Zusammenschau der Figuren 1 und 2 ergibt sich ferner, daß die Düse 18 beziehungsweise der Mündungsabschnitt 20 so ausgerichtet sind, daß der Ätzflüssigkeitsstrahl 22 unter einem Winkel alpha (hier: 20 Grad) zur Ebene E des Wafers 10 ausgerichtet ist und gleichzeitig tangential (Figur 1) in Bezug auf die Waferkante 10k geführt wird.

Dabei kann der Strahl 22 - entgegen der Darstellung in Figur 3 - so gezielt auf die Oberseite 10ko der Waferkante 10k gerichtet werden, daß er vollständig auf die Oberseite 10ko trifft (Figuren 1, 2) und nicht - wie in Figur 3 dargestellt - ein Teilstrom seitlich an der Spitze 10ks vorbeiströmt.

In jedem Fall wird, ausgehend von der Spitze 10ks, die Waferkante 10k weggeätzt (gebrochen) und damit in gewünschter definierter Weise entschärft.

Die aufgrund der Rotation des Wafers 10 anschließend wieder abgeschleuderte Ätzflüssigkeit kann in einer (nicht dargestellten) Aufnahme aufgefangen und rezykliert werden.

## Patentansprüche

1. Vorrichtung zum Naßätzen einer Kante (10k) einer Halbleiterscheibe (10), mit folgenden Merkmalen:
1.1 einem Träger (12) mit einer Trägerfläche (12f) zur rotierenden Aufnahme der Halbleiterscheibe (10), sowie
1.2 einer oberhalb der Halbleiterscheibe (10) angeordneten Düse (18), deren Mündungsabschnitt (20) so ausgebildet und ausgerichtet ist, daß ein über den Mündungsabschnitt (20) austretender Ätzflüssigkeitsstrahl (22) unter einem Winkel > 0 und < 90 Grad zur Ebene (E) der Halbleiterscheibe (10) auf einen definierten Flächenabschnitt der Kante (10k) der zu behandelnden Halbleiterscheibe (10) auftrifft.

2. Vorrichtung nach Anspruch 1, bei der der Mündungsabschnitt (20) der Düse (18) so ausgerichtet ist, daß der Ätzflüssigkeitsstrahl (22) tangential zur Kante (10k) der Halbleiterscheibe (10) verläuft.

3. Vorrichtung nach Anspruch 1, bei der der Mündungsabschnitt (20) der Düse (18) so ausgerichtet ist, daß der Ätzflüssigkeitsstrahl (22) ausschließlich auf einen der Düse (18) zugewandten Flächenabschnitt (10ko) der Kante (10k) der Halbleiterscheibe (10) auftrifft.

4. Vorrichtung nach Anspruch 1, bei der die Düse (18) so ausgebildet und angeordnet ist, daß der Ätzflüssigkeitsstrahl (22) beim Auftreffen auf die Kante (10k) der Halbleiterscheibe (10) eine Strömungsgeschwindigkeit aufweist, die maximal der Umfangsgeschwindigkeit der Halbleiterscheibe (10) entspricht.

5. Vorrichtung nach Anspruch 1, bei der der Träger (12) mindestens eine, in die Trägerfläche (12f) mündende Düse (14, 16) zur Aufnahme der Halbleiterscheibe (10) nach dem Bernoulli-Prinzip aufweist.

6. Vorrichtung nach Anspruch 1, bei der der Mündungsabschnitt (20) so ausgebildet und ausgerichtet ist, daß ein über den Mündungsabschnitt (20) austretender Ätzflüssigkeitsstrahl (22) unter einem Winkel zwischen 1 und 25 Grad zur Ebene (E) der Halbleiterscheibe (10) auf die Kante (10k) der zu behandelnden Halbleiterscheibe (10) auftrifft.

7. Vorrichtung nach Anspruch 1, bei der der Mündungsabschnitt (20) der Düse (18) einen Durchmesser zwischen 0,2 und 1,0 mm aufweist.

8. Vorrichtung nach Anspruch 1, bei der der Träger (12) mindestens eine, in die Trägerfläche (12f) mündende Düse aufweist, die zur Fixierung der Halbleiterscheibe mit Unterdruck beaufschlagbar ist.

9. Vorrichtung nach Anspruch 1, bei der der Träger (12) einen Durchmesser aufweist, der kleiner ist als der Durchmesser der zu behandelnden Halbleiterscheibe.

## Claims

1. Device for wet-etching of an edge (10k) of a semiconductor disc (10), having the following features:
1.1 a carrier (12) with a carrier surface (12f) for rotational reception of a semiconductor disc (10), and
1.2 a nozzle (18) disposed above the semiconductor disc (10), the outlet portion (20) of which nozzle is configured and orientated such that a stream of etching liquid (22), which emerges via the outlet portion (20), impinges on a defined surface portion of the edge (10k) of the semiconductor disc (10) to be treated at an angle > 0 and < 90° to the plane (E) of the semiconductor disc (10).

2. Device according to claim 1, in which the outlet portion (20) of the nozzle (18) is orientated such that the stream of etching liquid (22) extends tangentially to the edge (10k) of the semiconductor disc (10).

3. Device according to claim 1, in which the outlet portion (20) of the nozzle (18) is orientated such that the stream of etching liquid (22) impinges exclusively on a surface portion (10ko) of the edge (10k) of the semiconductor disc (10), which surface portion is orientated towards the nozzle (18).

4. Device according to claim 1, in which the nozzle (18) is configured and disposed such that the stream of etching liquid (22) has a flow velocity, which corresponds maximally to the circumferential velocity of the semiconductor disc (10), when impinging on the edge (10k) of the semiconductor disc (10).

5. Device according to claim 1, in which the carrier (12) has at least one nozzle (14, 16) opening onto the carrier surface (12f) in order to receive the semiconductor disc (10) according to the Bernoulli principle.

6. Device according to claim 1, in which the outlet portion (20) is configured and orientated such that a stream of etching liquid (22), which emerges via the outlet portion (20), impinges on the edge (10k) of the semiconductor disc (10) to be treated at an angle between 1 and 25° to the plane (E) of the semiconductor disc (10).

7. Device according to claim 1, in which the outlet portion (20) of the nozzle (18) has a diameter of between 0.2 and 1.0 mm.

8. Device according to claim 1, in which the carrier (12) has at least one nozzle opening onto the carrier surface (12f), which nozzle can be actuated at low pressure in order to fix the position of the semiconductor disc.

9. Device according to claim 1, in which the carrier (12) has a diameter which is smaller than the diameter of the semiconductor disc to be treated.

## Revendications

1. Dispositif pour la gravure humide d'un bord (10k) d'une plaquette semi-conductrice (10) présentant les caractéristiques suivantes:
1.1 un support (12) avec une surface de support (12f) pour tenir, en assurant sa rotation, la plaquette semi-conductrice (10), ainsi
1.2 qu'une buse (18) qui est disposée au-dessus de la plaquette semi-conductrice (10) et dont le tronçon d'embouchure (20) est conformé et orienté de manière telle qu'un jet de liquide de gravure (22) sortant dudit tronçon d'embouchure (20) arrive sur une portion de surface du bord (10k) définie de la plaquette semi-conductrice à traiter (10), sous un angle > 0° et < 90° par rapport au plan (E) de la plaquette semi-conductrice (10).

2. Dispositif selon la revendication 1, dans lequel le tronçon d'embouchure (20) de la buse (18) est orienté de telle sorte que le jet (22) de liquide de gravure soit tangentiel au bord (10k) de la plaquette semi-conductrice (10).

3. Dispositif selon la revendication 1, dans lequel le tronçon d'embouchure (20) de la buse (18) est orienté de telle sorte que le jet (22) de liquide de gravure arrive exclusivement sur une portion de surface (10ko) du bord (10k) de la plaquette semi-conductrice (10) tournée vers la buse (18).

4. Dispositif selon la revendication 1, dans lequel la buse (18) est conformée et orientée de telle sorte que le jet de liquide de gravure (22), à son arrivée sur le bord (10k) de la plaquette semi-conductrice (10), présente une vitesse d'écoulement qui, au maximum, correspond à la vitesse périphérique de la plaquette semi-conductrice (10).

5. Dispositif selon la revendication 1, dans lequel le support (12) comporte au moins une buse (14,16) qui débouche dans la surface de support (12f) pour tenir la plaquette semi-conductrice (10) selon le principe de Bernoulli.

6. Dispositif selon la revendication 1, dans lequel le tronçon d'embouchure (20) est conformé de telle sorte qu'un jet (22) de liquide de gravure qui sort par l'intermédiaire dudit tronçon d'embouchure (10) arrive sur le bord (10k) de la plaquette semi-conductrice (10) à traiter sous un angle compris entre 1 et 25 degrés par rapport au plan (E) de la plaquette semi-conductrice (10).

7. Dispositif selon la revendication 1, dans lequel le tronçon d'embouchure (20) de la buse (18) présente un diamètre compris entre 0,2 et 1,0 mm.

8. Dispositif selon la revendication 1, dans lequel le support (12) présente au moins une buse qui débouche dans dans la surface de support (12f) et peut être alimentée avec une pression négative aux fins de tenir la plaquette semi-conductrice.

9. Dispositif selon la revendication 1, dans lequel le support (12) présente un diamètre qui est inférieur au diamètre la plaquette semi-conductrice à traiter.
